# EUROPEAN PATENT APPLICATION

(11) **EP 4 700 420 A2**
(43) Date of publication of application: **25.02.2026**
(21) Application number: 25190142.7
(22) Date of filing: 17.07.2025
(51) Int. Cl.: G01R 33/54, G01R 33/567

(54) **MAGNETIC RESONANCE IMAGING APPARATUS AND METHOD OF CONTROLLING THE SAME**

(30) Priority: 21.08.2024 JP 2024139972
(71) Applicant: FUJIFILM Corporation, Tokyo 106-8620 (JP)
(72) Inventor: ATSUSHI, Kuratani, Tokyo, 106-8620 (JP)
(74) Representative: Dehns Germany Partnerschaft mbB

(57) **Abstract**

The present invention aims to reduce artifacts that occur in a re-captured image after imaging is interrupted due to a body movement, and to suppress extension in imaging time due to re-measurement as much as possible, thereby suppressing prolongation of the imaging time.

In a case where re-measurement is performed after the body movement occurs, an artifactsuppression dummy scan including a plurality of dummy RF irradiation pulses is inserted. In this case, a period of the dummy scan is optimized to reduce the re-measurement time including the dummy scan. This makes it possible to quickly restore a steady state that has been disrupted by the body movement while preventing extension in imaging time, thereby suppressing the occurrence of the artifacts.

## Description

### CROSS-REFERENCE TO RELATED APPLICATIONS

The present application claims priority under 35 U.S.C. §119 to Japanese Patent Application No. 2024-139972, filed August 21, 2024. Each of the above application(s) is hereby expressly incorporated by reference, in its entirety, into the present application.

### BACKGROUND OF THE INVENTION

### 1. Field of the Invention

The present invention relates to a magnetic resonance imaging apparatus (hereinafter, referred to as an MRI apparatus), and particularly relates to control for the MRI apparatus in a case where imaging is interrupted during an examination.

### 2. Description of the Related Art

In a case where a subject makes a sudden movement (body movement) during the examination using the MRI apparatus, echo signals collected at that time are encoded differently from the intended encoding, and artifacts caused by the body movement appear in an image reconstructed with k-space data including signals affected by the body movement. In order to remove the effects of the body movement, various techniques (body movement correction techniques) of correcting the signals affected by the body movement have been proposed (JP2023-022669A).

Since the contrast of the image is generally determined by low frequency data centered on the origin (zero encoding) of the k-space data, in a case where a body movement occurs during collection of the low frequency data and there is a large amount of low frequency data that requires correction, it is difficult to obtain a diagnostically useful image. In addition, in a case where the magnitude of the body movement itself is large, it may take time to return to the normal state, and the body movement correction technique may not be applicable. In a case where the image reconstruction or the body movement correction is difficult as described above, it is necessary to re-take the image.

JP2023-022669A discloses that body movement correction is selected depending on the number of pieces of measurement data affected by body movement and a position in the k-space, that is, whether the data is low frequency data or high frequency data, and that re-measurement is performed in a case where the body movement correction fails to yield a diagnostic image. In this case, instead of re-taking all the k-space data, the k-space data collected before the body movement occurs is stored, and the k-space data at the time at which the body movement occurs and the k-space data thereafter are collected. Accordingly, it is possible to prevent the imaging time from being prolonged due to the re-imaging.

### SUMMARY OF THE INVENTION

As described above, there is a problem in that an artifact such as a body movement artifact occurs even in a case where data in a case where the body movement occurs is re-measured and the image is reconstructed using data after the re-measurement, that is, data collected in a case where the body movement does not occur. This artifact is considered to be caused by the fact that a steady state of longitudinal magnetization is disrupted due to the effects of the body movement even in a case where a subject position returns to its original position. JP1991-121046A (JP-H3-121046A) discloses that, in a case where the measurement is performed again after imaging interruption, although this is not re-measurement after the occurrence of the body movement, dummy measurement is performed in order to return a state of the longitudinal magnetization of spins to a state before the interruption. In this dummy measurement, MRI signals are not measured, and the number of encoding steps and the like are not updated.

However, the dummy measurement after the imaging interruption as disclosed in JP1991-121046A (JP-H3-121046A) is intended to return the longitudinal magnetization relaxed by the interruption to a steady state, but an unstable state of the longitudinal magnetization caused by the body movement may cause artifacts even in a case where the re-measurement is performed immediately after the body movement occurs, and no knowledge has been obtained about the time (period in which the dummy measurement is performed) required to return to the state before the re-measurement after the body movement has subsided. In addition, in a case where a dummy scan is inserted during the re-measurement in the same manner as in JP1991-121046A (JP-H3-121046A), the re-measurement time is extended, which is highly likely to cause a new problem of prolonged overall imaging time.

An object of the present invention is to reduce artifacts that occur in a re-captured image after imaging is interrupted due to a body movement. In addition, an object of the present invention is to suppress extension in imaging time due to re-measurement as much as possible and to suppress prolongation of the imaging time.

In the present invention, in a case where re-measurement is performed after the body movement occurs, an artifact-suppression scan (hereinafter, referred to as a dummy scan) including a plurality of dummy RF irradiation pulses is inserted. In this case, the re-measurement including the dummy scan is optimized, such as a period of the dummy scan, to reduce the re-measurement time including the dummy scan. This makes it possible to quickly restore a steady state that has been disrupted by the body movement while preventing extension in imaging time, thereby suppressing the occurrence of the artifacts.

That is, an MRI apparatus according to an aspect of the present invention comprises: an imaging unit that collects nuclear magnetic resonance signals of a subject; an image generation unit that reconstructs an image of the subject using k-space data consisting of the nuclear magnetic resonance signals collected by the imaging unit; a body movement processing unit that analyzes a body movement of the subject during imaging and that specifies correction target data affected by the body movement of the subject; and an imaging controller that controls the imaging unit. In a case where re-measurement of the correction target data is required, the imaging controller controls the imaging unit to execute a dummy scan of performing one or more times of RF pulse irradiation to generate dummy signals that are not used for image reconstruction, prior to the re-measurement of the correction target data.

In addition, a method of controlling an MRI apparatus according to another aspect of the present invention comprises: a step of specifying correction target data affected by a body movement of a subject in k-space data acquired during imaging; and a step of controlling imaging to execute a dummy scan of performing one or more times of RF pulse irradiation to generate dummy signals that are not used for image reconstruction, in a case where the correction target data is re-measured.

According to the present invention, in a case where imaging is interrupted due to a body movement and data that has not been acquired up until that point is re-measured, it is possible to prevent an artifact, such as a body movement artifact, from occurring in an image reconstructed using re-measurement data while minimizing the time related to the re-measurement.

### BRIEF DESCRIPTION OF THE DRAWINGS

Fig. 1 is a diagram showing an overall outline of an MRI apparatus to which the present invention is applied.
Fig. 2 is a block diagram showing an example of a function of an imaging controller.
Fig. 3 is a diagram showing an embodiment of an operation of the MRI apparatus.
Figs. 4A and 4B are diagrams showing an example of a case where re-measurement is performed.
Fig. 5 is a diagram showing an example of region division of a k-space.
Fig. 6 is a diagram showing an example of a processing flow of the imaging controller of Embodiment 1.
Fig. 7A is a diagram showing an example of re-measurement according to Embodiment 1.
Fig. 7B is a diagram showing another example of re-measurement according to Embodiment 1.
Fig. 8 is a diagram illustrating re-measurement of a modification example of Embodiment 1.
Fig. 9 is a diagram illustrating determination of start of a main scan for re-measurement according to Modification Example 2 of Embodiment 1.
Fig. 10 is a diagram showing a re-measurement example and k-space data according to Embodiment 2.
Fig. 11 is a diagram showing an example of a re-measurement control in a case where a body movement occurs during low frequency data collection.
Fig. 12 is a diagram illustrating an example of omission of measurement of k-space data of Embodiment 2.

### DESCRIPTION OF THE PREFERRED EMBODIMENTS

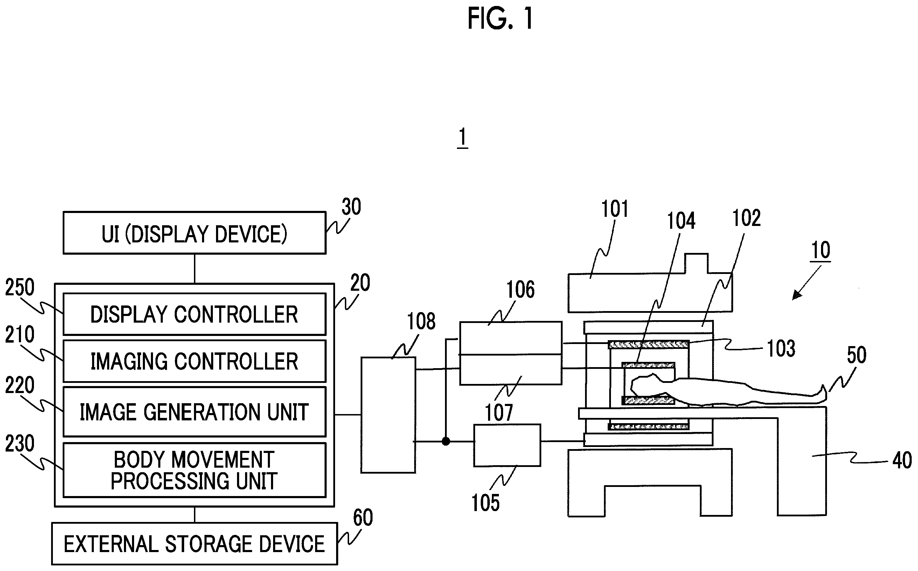

First, an outline of an MRI apparatus to which the present invention is applied will be described with reference to Fig. 1.

As shown in Fig. 1, an MRI apparatus 1 is roughly divided into an imaging unit 10, a processor 20 that performs various controls and calculations, and a user interface (UI) unit 30 that allows communication between the imaging unit 10 and the processor 20 and a user. Main elements constituting the imaging unit 10 are housed in a gantry that provides an examination space.

The imaging unit 10 induces nuclear magnetic resonance in nuclei (usually protons) of atoms that constitute a tissue of a subject, and collects nuclear magnetic resonance signals (NMR signals) generated by the resonance from the subject. Hereinafter, the nuclear magnetic resonance signal is also simply referred to as a signal or an echo signal.

A configuration of the imaging unit 10 is similar to that of a known MRI apparatus, and comprises a static magnetic field magnet 101 that generates a uniform magnetic field (static magnetic field) in the examination space in which a subject 50 is placed, a gradient magnetic field coil 102 that applies a gradient magnetic field to the static magnetic field, an RF transmission coil 103 that applies a radiofrequency magnetic field to excite the nuclei of the atoms constituting the tissue of the subject, and an RF receive coil 104 that receives the NMR signal generated by the subject, in which the gradient magnetic field coil 102, the RF transmission coil 103, and the RF receive coil 104 are connected to a gradient magnetic field power supply 105, a transmitter 106, and a receiver 107, respectively. Operations of the gradient magnetic field power supply 105, the transmitter 106, and the receiver 107 are controlled by a sequencer 108. The sequencer 108 determines a pulse sequence for each scan using a set pulse sequence type and imaging conditions such as imaging parameters, and controls each component of the imaging unit 10 to operate in accordance with the determined pulse sequence and collect an echo signal (k-space data) necessary for image reconstruction. Since functions and operations of each component in a case where the imaging unit 10 collects the k-space data are similar to those of a general MRI apparatus, detailed description thereof will be omitted here.

The static magnetic field magnet 101, the gradient magnetic field coil 102, and the RF transmission coil 103 are housed in the gantry, and the subject 50 is positioned in the examination space in the gantry in a state of being laid on a bed device 40 with the RF receive coil 104 attached to an examination part.

The processor 20 is a device that performs control and calculation of the device, and can be configured as a known processing device such as a computer comprising a CPU and a memory, a programmable IC, or a combination thereof. In a case of a computer, the processing of the processor is realized by the CPU reading a program that achieves each function of control or calculation. In addition, all of the functions of the processor can be realized by a single processor, but each function can also be realized by a combination of one or a plurality of processors. In Fig. 1, one processor 20 represents one or a plurality of processors, and individual functions realized by one or a plurality of processors 20 are shown.

In the example of Fig. 1, the processor 20 comprises an imaging controller 210 that controls the operation of the imaging unit 10, an image generation unit 220 that generates an image of the subject using the echo signal collected by the imaging unit 10, a body movement processing unit 230 that performs processing related to the body movement of the subject 50 during the examination, and a display controller 250 that controls a GUI for displaying the image generated by the image generation unit 220 and for interacting with the user. Fig. 1 illustrates typical functions of the processor 20 of the present embodiment, and each function does not necessarily correspond to an individual processor or processing unit. In some cases, one processor or processing unit realizes functions of a plurality of functional units, or a plurality of processors or a plurality of processing units realize one function.

The imaging controller 210 controls the imaging unit 10 via the sequencer 108 that operates each element of the imaging unit 10 in accordance with a predetermined pulse sequence. The sequencer 108 operates each component of the imaging unit 10 based on imaging conditions such as a pulse sequence and a scan parameter, which are determined by an examination flow or set by the user. The imaging controller 210 performs control of stopping or resuming the imaging according to the body movement analyzed by the body movement processing unit 230, and performs control of re-measurement of re-taking a part of the k-space data affected by the body movement.

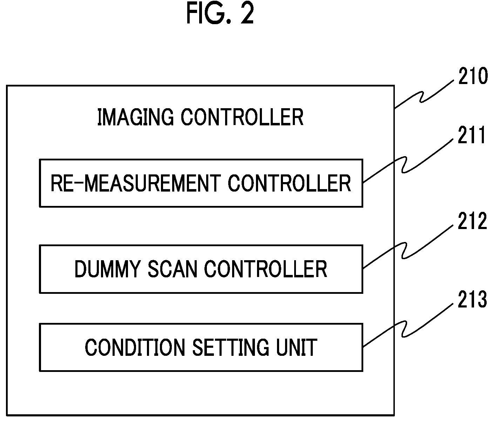

In the control of the re-measurement, in a case where the body movement occurs during the imaging and the k-space data being acquired is remeasured, the imaging unit 10 is controlled to execute the dummy scan. The dummy scan is a scan for performing one or more times of RF pulse irradiation to generate dummy signals that are not used for image reconstruction prior to a scan (main scan) for re-taking the k-space data affected by the body movement. Fig. 2 is a functional block diagram of the re-measurement control in the imaging controller 210. The imaging controller 210 can comprise a re-measurement controller 211 that controls the main scan of the re-measurement, a dummy scan controller 212, a condition setting unit 213 that determines conditions for the re-measurement including the dummy scan, and the like. As described above, these functions are executed by one or a plurality of processors. Details of the re-measurement control will be described below.

The image generation unit 220 performs calculations necessary for image reconstruction, such as Fourier transform and sequential calculations, on the k-space data collected by the imaging unit 10, and performs calculations such as correction on the k-space data before reconstruction or the image after reconstruction. In the present embodiment, image reconstruction (body movement-corrected reconstruction) in which the body movement is corrected is performed according to the body movement analyzed by the body movement processing unit 230. In addition, in a case where a part of the k-space data is re-measured by the imaging unit 10, the k-space data obtained by the re-measurement and the k-space data obtained before the re-measurement may be combined to perform image reconstruction.

The body movement processing unit 230 collects and processes body movement information occurring in the subject 50 during the examination, for example, a size and a duration of the body movement, and associates the body movement information with the ongoing scan (imaging) to determine whether or not body movement correction is necessary and whether or not re-measurement is necessary. The body movement information can be acquired from body movement detection means such as a surveillance camera for monitoring the movement of the subject 50 and a navigator echo for detecting the movement of the subject. One or a plurality of surveillance cameras are installed in the vicinity or inside of the gantry, acquire a video of the examination space, and transmit the video to the processor 20. The navigator echo is a nuclear magnetic resonance signal collected to detect the movement of the subject, separately from the nuclear magnetic resonance signal (echo signal) for the imaging unit 10 to generate the image of the subject, and the body movement processing unit 230 extracts the movement of the subject at the time of imaging by analyzing the navigator echoes acquired in time series.

The display controller 250 causes a display device to display the image generated by the image generation unit 220 or accessory information of the image in a predetermined display form. The display controller 250 further performs processing of displaying, on the display device, a GUI for the user to input various conditions or settings related to the operation of the MRI apparatus 1, such as imaging, image generation (including correction), and display, receiving the user settings, and passing the user settings to the related functional unit. The UI unit 30 comprises a display device, an input device, and the like as means for the processor 20 and the user to communicate with each other, and these are connected to the processor 20.

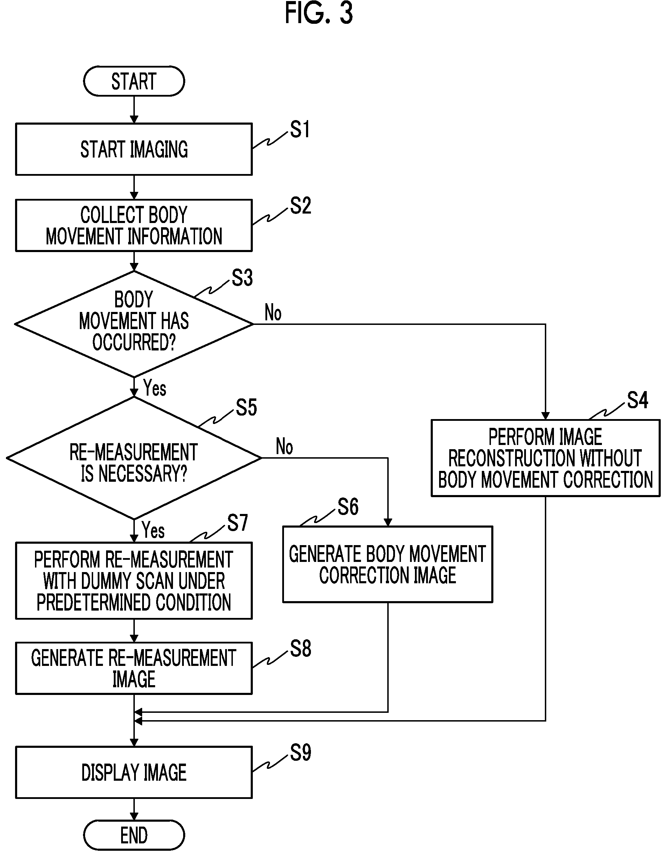

Next, a flow of an imaging operation of the MRI apparatus 1 in the above configuration will be described with reference to Fig. 3.

The subject 50 is placed in the examination space, and imaging is started (S1). Specific conditions for imaging, that is, a pulse sequence and scan parameters (the number of slices, FOV, TE, TR, R factor, and the like) used for imaging are not particularly limited, and imaging is executed by setting various known conditions using known setting methods.

Before or simultaneously with the start of imaging, the body movement processing unit 230 monitors a movement of the subject and collects body movement information (S2). The movement of the subject can be acquired, for example, by collecting navigator echoes for monitoring the movement of the subject separately from the echo signal for image reconstruction, and analyzing a change in a profile obtained by performing Fourier transform on the navigator echoes in a direction of the movement to be monitored or a change in the navigator echoes themselves. Since various sequences are known as a pulse sequence for collecting navigator echoes and an imaging sequence accompanying the pulse sequence, specific description of the sequences will be omitted here.

In addition, instead of using the navigator echo, it is also possible to obtain the movement from a video from a surveillance camera installed in the gantry of the MRI apparatus 1 or in the vicinity of the gantry or a signal of a biological signal monitor worn by the subject, or to use both the video and the signal. The body movement processing unit 230 analyzes the video or the signal and collects body movement information such as the magnitude of the body movement, information regarding a body movement occurrence time, and a type of the body movement. For the acquisition of the movement information using the video of the surveillance camera, for example, a known method such as an optical flow calculation between frame images can be adopted. In addition, in a case where a respiratory movement, heart rate, or the like is obtained as a biological signal, it is also possible to discriminate the presence or absence of a body movement that affects the image by using the signal.

As a result of the analysis of the body movement processing unit 230, in a case where no body movements that affect the image, such as sudden movements excluding a relatively small periodic movement such as a respiratory movement and heart rate, or positional deviations are detected, and in a case where measurement data (k-space data) necessary for reconstructing the image is collected, the image generation unit 220 performs the image reconstruction using a known image reconstruction method such as Fourier transform or PI calculation using the collected k-space data (S4).

As a result of the analysis of the body movement processing unit 230, in a case where it is determined that the body movement has occurred during the collection of the k-space data (S3), the body movement processing unit 230 specifies measurement data affected by the body movement based on the body movement occurrence time point. Further, the body movement processing unit 230 uses the data affected by the body movement to determine whether to perform the body movement correction image reconstruction as it is or to perform the re-measurement (S5). The determination of whether or not to perform the re-measurement can be performed based on the magnitude and the duration of the body movement, and additionally, the determination is performed based on a proportion of the correction target data, that is, a proportion of the correction target data to the total data in the k-space, and a proportion of the correction target data in the low frequency region in the k-space. Specifically, in a case where any one of the proportion of the correction target data to the total data in the k-space or the proportion of the correction target data in the low frequency region in the k-space exceeds a threshold value, it is determined that the re-measurement is required without performing the body movement correction.

In a case where the body movement correction is possible, the image generation unit 220 generates a body movement correction image using a predetermined method (S6). As a method of the body movement correction, known methods such as zero-filling in which correction target data is deleted and filled with zero, half scan reconstruction, reconstruction in which data estimation is performed using the k-space Hermitian symmetry, and sequential reconstruction using k-space data after zero-filling can be adopted.

After it is determined that the body movement has occurred (S3), the measurement data affected by the body movement and the subsequent unmeasured measurement data may be automatically re-measured (S6) without determining whether or not the re-measurement in step S5 is necessary.

In a case where it is determined that the body movement correction is not possible or it is determined that the re-measurement is necessary, the imaging controller 210 automatically controls the imaging unit 10 to perform the re-measurement or the user selects the re-measurement. That is, the imaging unit 10 stores the k-space data acquired up until the occurrence of the body movement in the memory and re-measures the k-space data after the time point at which the body movement occurs (S7). In this case, the imaging controller 210 controls the imaging unit 10 to execute a predetermined dummy scan prior to collection of the echo signals for image reconstruction.

The dummy scan is a scan in which echo signals (dummy echoes) that are not used for image reconstruction are generated, and the imaging controller 210 (condition setting unit 213) sets conditions for the dummy scan (conditions of re-measurement including the dummy scan), such as the number of dummy echoes or a period in which the dummy scan is executed, and whether or not to perform phase encoding on the dummy echo, and controls the imaging unit 10. The conditions for the dummy scan are determined in consideration of the amount of measurement data collected by the re-measurement and the position in the k-space while minimizing the extension in the time due to the re-measurement. By executing the dummy scan under appropriate conditions, it is possible to perform re-measurement in the same state as before the re-measurement (steady state of longitudinal magnetization), and it is possible to suppress artifacts in an image reconstructed using the re-measurement data. Specific conditions for the re-measurement will be described in the embodiments described below.

In a case where the conditions are set, the imaging unit 10 executes the re-measurement under the control of the re-measurement controller 211 and the dummy scan controller 212 in accordance with the conditions (S7). In a case where the measurement data necessary for the image reconstruction is collected by the dummy scan and the re-measurement, the image generation unit 220 generates an image using the measurement data before the re-measurement stored in the memory and the data collected after the re-measurement (S8).

The image generated by the image generation unit 220 is displayed on the display device of the UI unit 30 via the display controller 250 (S9). In addition, the image data may be transmitted to an external storage device, a database, or the like.

With the MRI apparatus according to the present embodiment, in a case where it is necessary to re-capture an image due to the occurrence of the body movement, the dummy scan is executed during the re-measurement, thereby preventing artifacts from occurring in an image reconstructed using the k-space data including the re-measurement data. In addition, by appropriately controlling the conditions for the re-measurement including the dummy scan, it is possible to minimize the effects of the extension in the re-measurement time due to the addition of the dummy scan.

Next, an embodiment of specific control of the dummy scan and the re-measurement performed by the imaging controller 210 will be described. In the following embodiments, the configuration and the flow of the operation of the MRI apparatus and the processor thereof are the same as those of the above-described embodiment, and the drawings used in the above-described embodiment will be appropriately used in the description.

### Embodiment 1

In the present embodiment, in the dummy scan performed during the re-measurement, phase encoding steps are applied to the generated dummy echoes in the same manner as in normal imaging, and control is performed so that the dummy echo is not measured as data. Specifically, the dummy scan is executed from the phase encoding step retraced by a predetermined period from the time at which the body movement occurs, and, when the phase encoding step at the time point at which the body movement occurs is reached, re-measurement of echoes for image construction is started from that phase encoding step.

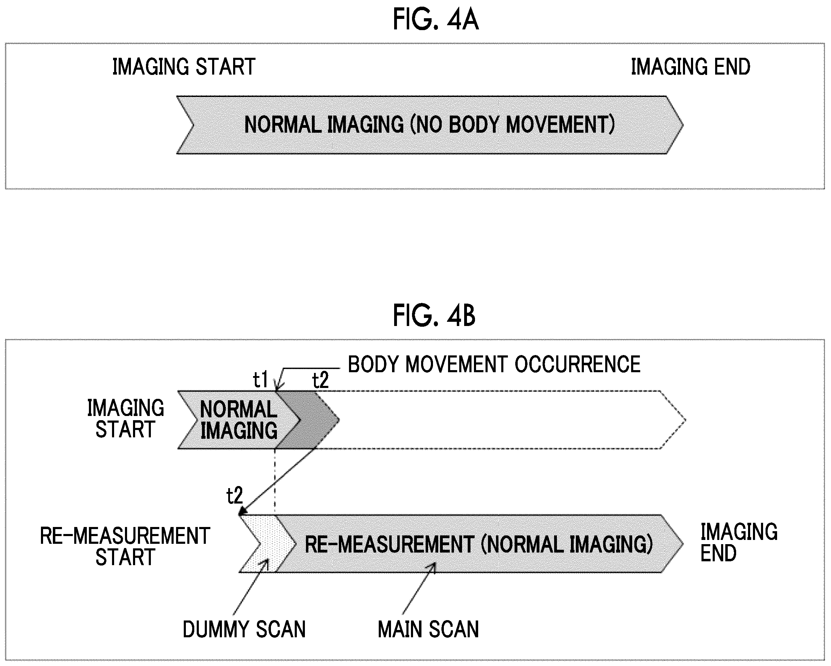

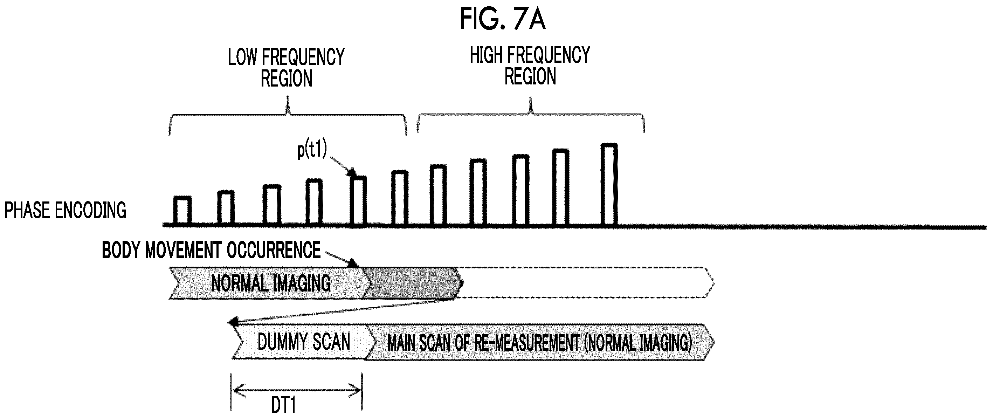

The control of the imaging controller 210 of the present embodiment will be described with reference to Figs. 4A and 4B. A horizontal direction of Figs. 4A and 4B is a direction along the ordering of the phase encoding, and the normal imaging before the occurrence of the body movement and the subsequent re-measurement do not overlap in time (the same applies to Figs. 7A and 7B and Figs. 8 and 10 below).

Fig. 4A shows a state in which no body movement occurs and normal imaging is performed. In the normal imaging, a pulse sequence is executed to collect echo signals for a predetermined number of phase encoding steps in a predetermined order (ordering) from the start of imaging to the end of imaging, and k-space data for image reconstruction is acquired. On the other hand, Fig. 4B shows a case where normal imaging is performed until halfway through, but the body movement occurs at time point t1. The body movement processing unit 230 analyzes the body movement information using the video of the surveillance camera or the navigator echo, specifies the echo signals collected from time point t1 at which the body movement occurs to predetermined time point t2 as data (correction target data) affected by the body movement, and further determines whether or not the re-measurement is necessary. In a case where it is determined that the re-measurement is necessary, the imaging controller 210 performs control of determining re-measurement target data including the correction target data and storing a part of the k-space data collected by the normal imaging before the occurrence of the body movement in the memory.

In a case where the re-measurement target data is specified, the imaging controller 210 determines the conditions for the re-measurement including the dummy scan based on a position (phase encoding) of the re-measurement target data in the k-space, the number of data points, the image type, and the like. In the present embodiment, a range of phase encoding performed by the dummy scan is determined as the conditions for the re-measurements. The length of the dummy scan (dummy scan period) is determined by the range of the phase encoding. In the present embodiment, the range of phase encoding starts from the phase encoding step at the time retraced from time point t1, that is, from the phase encoding step that is measured earlier than the phase encoding step at time point t1, and ends at the phase encoding step at time point t1. The period over which the phase encoding steps are retraced can be determined based on a predetermined time length or a predetermined number of RF pulse shots for generating dummy echoes.

For example, the predetermined time length and the predetermined number of shots may be determined as fixed values equivalent to or twice a period from time point t1 to time point t2, or may be determined or adjusted depending on the magnitude and the duration of the body movement and on the image type such as T1W and T2W.

As an example of determining the dummy scan period based on the magnitude and the duration of the body movement, in a case where the body movement is large, for example, in a case where the body movement is equal to or greater than a predetermined threshold value, the number of shots can be set to 100 or the dummy scan period can be set to 1 second, and, in a case where the body movement is small, for example, in a case where the body movement exceeds a threshold value but is within the predetermined threshold value, the number of shots can be set to 20 or the dummy scan period can be set to 0.5 seconds. In addition, in a case where the duration of the body movement is 1 second or longer, the number of shots can be set to 100 or the dummy scan period can be set to 1 second, and, in a case where the duration of the body movement is short, a time corresponding to the duration (or the number of shots in that time) can be set.

In addition, as an example of adjusting the dummy scan period based on the image type, for example, the dummy scan period of T1W imaging with a long TR may be shorter than the dummy scan period of T2W imaging. In addition, the number of shots of the dummy scan may be set based on a simulation or an empirical determination of a time taken for the echo to reach a steady state according to a TR, that is, an interval between RF pulses for excitation, of a pulse sequence different depending on the image type. In that case, the imaging controller 210 may be configured to select an appropriate time length or the number of shots according to the TR of the pulse sequence.

Further, the imaging controller 210 may adjust the dummy scan period or the number of RF pulse shots according to the arrangement of the re-measurement target data in the k space. In a case where the re-measurement target data is high frequency data in the k-space or in a case where the re-measurement target data to be measured at the beginning of the re-measurement is high frequency data in the k-space, the dummy scan period or the number of RF pulse shots may be reduced compared to the low frequency data. In a case where the re-measurement target data to be measured at the beginning of the re-measurement is low frequency data, the dummy scan period or the number of RF pulse shots may be increased beyond a predetermined period or a predetermined number.

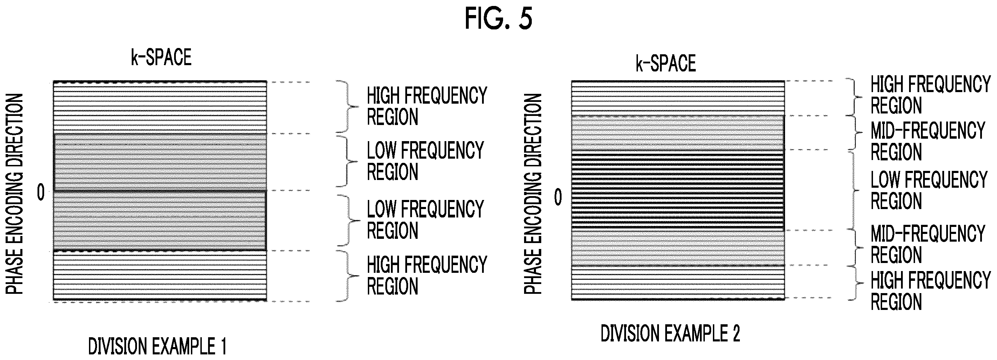

The criterion for dividing the k-space into the high frequency data and the low frequency data is not limited, but can be determined in advance, for example, as in Division Example 1 of Fig. 5, in which the central half of upper and lower regions bounded by the center of the k-space is the low frequency data, and the outer half is the high frequency data. In addition to the low and high frequency regions, a mid-frequency region may be set between the low frequency region and high frequency region as in Division Example 2 of Fig. 5. Even in a case where the dummy scan period or the number of RF pulse shots is adjusted based on the region of the k-space to which the correction target data belongs, a predetermined value may be set in advance, for example, 50% for the high frequency data relative to the low frequency data.

In a case of dividing the k-space into regions, the proportions of the low frequency region and the high frequency region and the adjustment proportions for each region may be adjustable according to the image quality desired by the user.

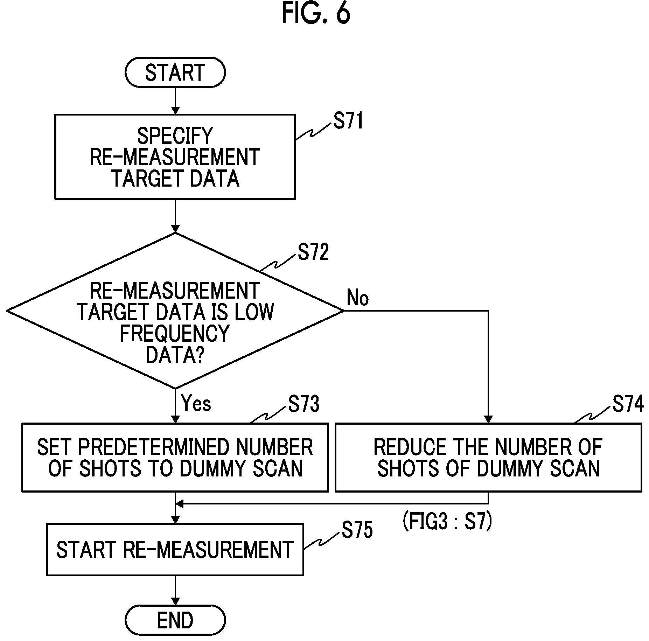

Fig. 6 shows an example of a flow of processing of the imaging controller 210 in a case where the k-space is divided into the high frequency data and the low frequency data and the conditions for the dummy scan are set. In a case where the imaging controller 210 specifies the re-measurement target data (S71), the imaging controller 210 determines whether the re-measurement target data is the high frequency data or the low frequency data (S72). In a case where the re-measurement target data is the low frequency data, the imaging controller 210 controls the imaging unit 10 using the dummy scan period or the number of shots set in advance as the dummy scan condition (S73, S75). On the other hand, in a case where the re-measurement target data is the high frequency data, the imaging controller 210 controls the imaging unit 10 to execute the dummy scan by retracing the phase encoding steps for the dummy scan period or the number of shots set in advance for the high frequency data (S74, S75).

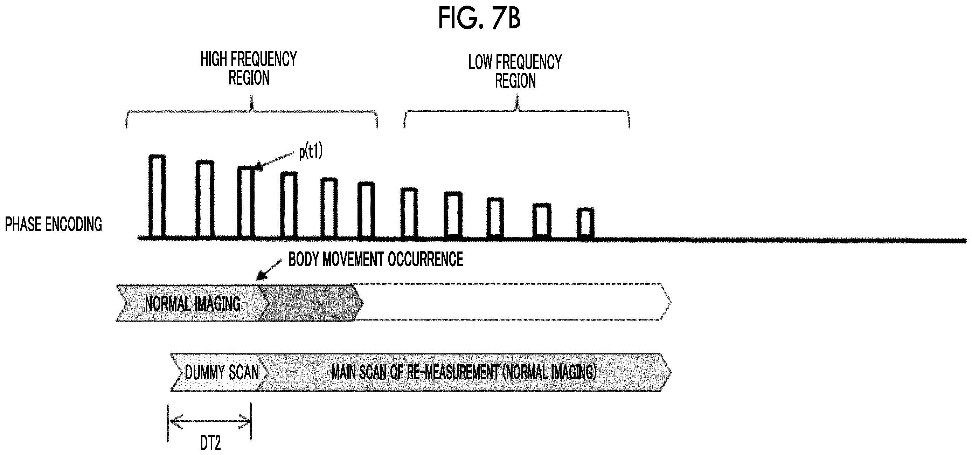

Based on the above description, a specific example of the re-measurement will be described with reference to Figs. 7A and 7B. Figs. 7A and 7B show, as an example, sequential ordering in which k-space data is measured in order along the phase encoding direction.

The example of Fig. 7A is an example in which the body movement occurs during measurement from the low frequency region to the high frequency region, and the re-measurement including the dummy scan is immediately started after the body movement occurs. The dummy scan, from the phase encoding step p(t1) at time point t1 at which the body movement occurs, starts dummy shots (RF pulse irradiation without measuring an echo) at the phase encoding step retraced in the ordering order for a predetermined number of shots, and generates dummy echoes up through the phase encoding step immediately preceding p(t1) at time point t1. In a case where the phase encoding step p(t1) at time point t1 is reached, the main scan of the re-measurement is started, the pulse sequence is continued by inheriting the ordering of the dummy scan, and the echoes to which the phase encoding step at time point t1 and subsequent phase encoding steps are applied are collected as echo data for image reconstruction. The re-measurement is performed until all unmeasured data are collected.

The example of Fig. 7B is an example in which the body movement occurs during the measurement of the high frequency data in a case where the measurement is performed from the high frequency region to the low frequency region. In this case as well, as in the example of Fig. 7A, the re-measurement including the dummy scan is immediately started after the body movement occurs, but the phase encoding step at which the dummy scan is started, that is, the number of phase encoding steps retraced is smaller than that in the case of Fig. 7A. As a result, a period DT2 of the dummy scan is shorter than a period DT1 of the dummy scan in Fig. 7A. After the dummy scan, the data after the phase encoding step at time point t1 at which the body movement occurs is collected in the same manner as in the example of Fig. 7A.

Figs. 7A and 7B are examples in which the dummy scan period, that is, the period over which the phase encoding steps are retraced is changed depending on which region of the k-space the phase encoding step at the time point at which the body movement occurs belongs to. However, as described above, the dummy scan may be executed in a predetermined dummy scan period regardless of the region of the k-space, or adjustment may also be made according to the magnitude of the body movement, the image type, or the like.

In either case, in a case where the re-measurement is performed and finally collection of the k-space data necessary for image reconstruction, including a part of the k-space data acquired by the normal imaging, is completed, the image generation unit 220 generates an image using the k-space data (Fig. 3: S8).

In a case where the body movement occurs again during the re-measurement, then according to the flow of Fig. 3, in a case where the body movement is correctable, the body movement correction image reconstruction is performed with the measurement data at the time of the occurrence of the body movement as the correction target data. In a case where the body movement correction is not sufficient, for example, in a case where the proportion of the correction target data in the low frequency region in the k-space exceeds a predetermined proportion, the re-measurement is performed. Even in this re-measurement, as described above, the dummy scan for a predetermined period is executed to collect the echoes for image reconstruction.

According to the present embodiment, by performing the dummy scan in the same pulse sequence as the normal imaging by retracing the phase encoding steps, it is possible to easily control the gradient magnetic field in the pulse sequence and realize the stabilization of the signal through the dummy scan in a short time, thereby preventing the re-measurement data from being affected by the body movement.

In addition, according to the present embodiment, the period in which the dummy scan is executed can be limited to an appropriate length for eliminating the effects of the body movement, thereby suppressing the extension in re-measurement time as much as possible.

In Fig. 7 used to describe the embodiment and the description thereof, the measurement order (ordering) of the k-space is sequential ordering as an example. However, the present embodiment and the modification examples and embodiments described below are not limited to the sequential ordering, and can also be applied to centric ordering in which sampling starts at the center of the k-space, that is, the low frequency region and then sequentially measures the upper and lower high frequency regions, and spiral scanning.

### Modification Example 1 of Embodiment 1

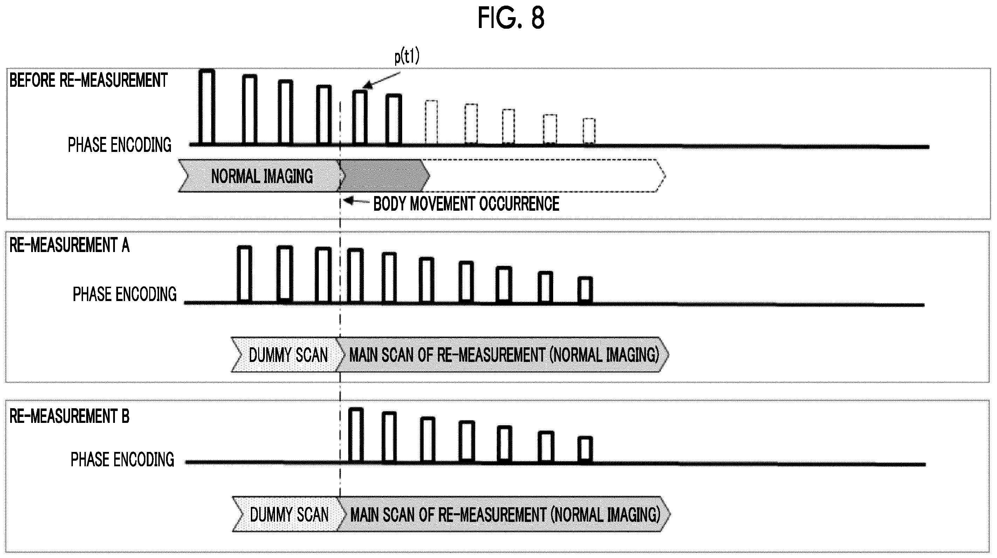

In the present modification example, in a case where the measurement data of the body movement range is re-measured, the dummy scan is executed as in Embodiment 1. However, in Embodiment 1, the dummy echoes to which the phase encoding steps are applied are collected in the dummy scan, whereas in the present modification example, no phase encoding steps are applied, that is, no phase encoding gradient magnetic fields are applied during the dummy scan to generate the dummy echoes. A lower part of Fig. 8 described above illustrates re-measurement B in a case where no phase encoding steps are applied.

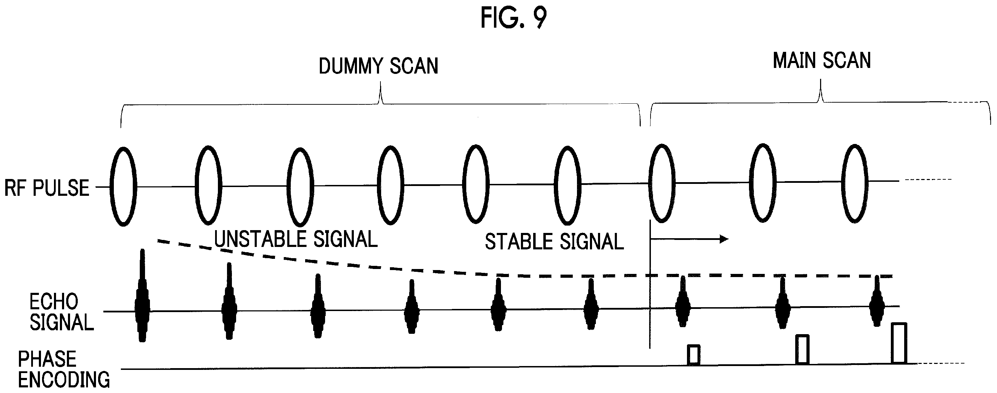

In the present modification example, the period in which the dummy scan is executed may be set to a predetermined period set in advance as in Embodiment 1. Here, a case where the time point of transitioning to the re-measurement is determined based on the signal intensity of the dummy echo will be described. The signal intensity of the dummy echo is unstable immediately after the start of the dummy scan due to the effects of the body movement, but, for example, as shown in Fig. 9, the signal intensity becomes stable at a certain intensity in a case where the longitudinal magnetization of the spin is in a steady state. Therefore, the imaging controller 210 monitors only the intensity change of the dummy echoes instead of collecting the dummy echoes as the k-space data, and determines that a steady state has been reached. Specifically, the imaging controller 210 determines that the steady state has been reached at a time point at which a signal intensity difference between adjacent echoes is equal to or less than a preset threshold value, and performs control of adding a phase encoding gradient magnetic field Gp to the pulse sequence from that time point and measuring the echoes. That is, the re-measurement (main scan) of the k-space data of the body movement range is started. A first phase encoding step of the main scan is the same as the phase encoding step at time point t1 at which the body movement occurs.

According to the present modification example, the control of the phase encoding gradient magnetic field is different from that of Embodiment 1, but since the dummy echo is not subjected to the phase encoding, the signal intensity does not change due to the difference in the gradient magnetic field, and the stable state of the echo can be known from the change in signal intensity. Therefore, it is possible to efficiently set the period of the dummy scan regardless of the type of the pulse sequence and to minimize the extension in the time due to the addition of the dummy scan.

### Modification Example 2 of Embodiment 1

In Embodiment 1, the dummy scan is started by retracing from the phase encoding step at time point (t1) at which the body movement occurs, and the phase encoding steps are changed according to the ordering, but the dummy scan may be performed while the phase encoding step is kept constant. The phase encoding step in this case is not particularly limited, but may be, for example, the same as the phase encoding step at the time point at which the body movement occurs, or a phase encoding step in the vicinity thereof. An example of re-measurement A according to the present modification example is shown in a middle part of Fig. 8. An upper part of Fig. 8 is imaging before re-measurement in which the body movement occurred during imaging. In the re-measurement A, the dummy scan is executed at the phase encoding step p(t1) at the time point at which the body movement occurs. The imaging controller 210 fixes the phase encoding step p(t1) during the dummy scan and measures the data to be re-measured while changing the phase encoding step in the main scan of the re-measurement A.

In this modification example, since the phase encoding step is held constant, the dummy echoes do not include any variations arising from different phase encoding steps and, as in Modification Example 1, it is possible to detect that the stable state has been reached from changes in the dummy echoes.

### Embodiment 2

In the present embodiment, as shown in Fig. 5, the k-space is divided into a low frequency region and a high frequency region, and measurement of some data is omitted in the re-measurement depending on which region's data was being measured at the time point at which the body movement occurs, thereby preventing the time extension due to the dummy scan.

In the present embodiment as well, in a case where the body movement processing unit 230 determines to re-measure the k-space data subsequent to the re-measurement target data, the imaging controller 210 controls the imaging unit 10 to add the dummy scan of a predetermined period prior to the main scan, as in Embodiment 1 or a modification example thereof. In the present embodiment, the imaging controller 210 further determines high frequency data that is not collected from k-space data measured in the main scan of the re-measurement, and controls the imaging unit 10 to perform the re-measurement by omitting the collection of a part of the high frequency data.

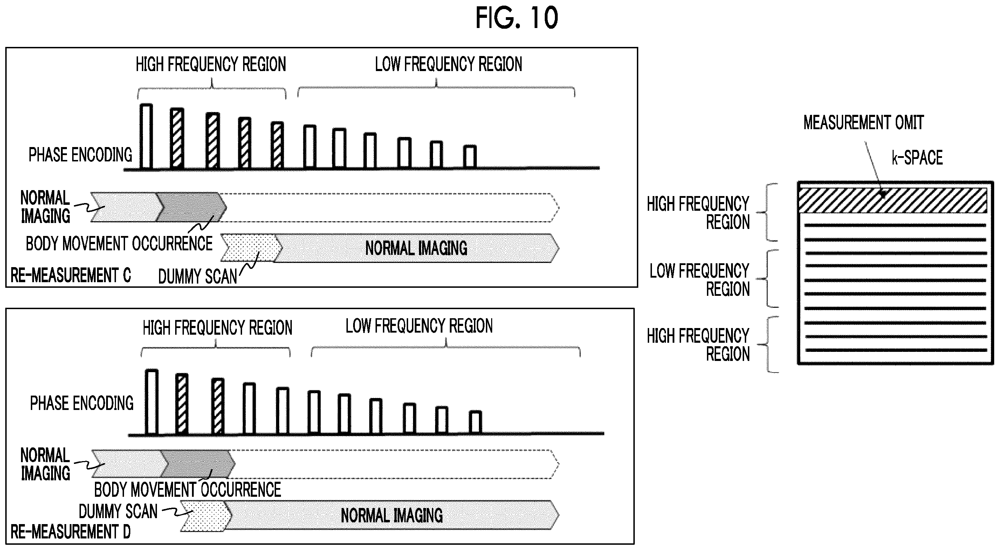

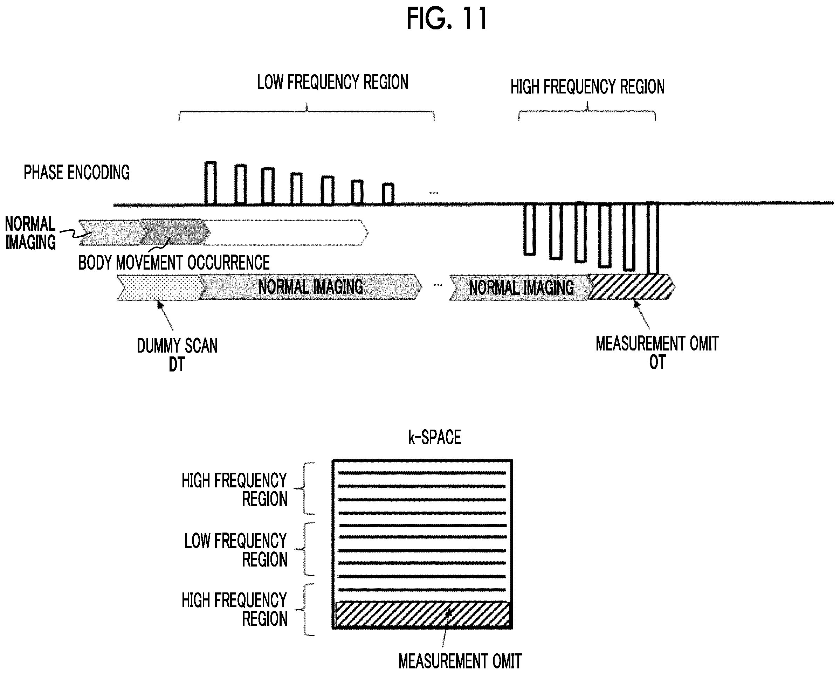

Figs. 10 and 11 show an example of the control of the re-measurement according to the present embodiment.

The example shown in Fig. 10 shows a case where a body movement occurs during the measurement of the high frequency data in a case where the k-space is measured from the high frequency data to the low frequency data on the upper side. In Embodiment 1, for example, as shown in Fig. 7A, all the data after the body movement occurrence is re-measured, but, in the present embodiment, instead of measuring all the data after the body movement occurrence, at least partial measurement is omitted. In the example shown on the upper side of Fig. 10 (re-measurement C), after it is determined that re-measurement is necessary because of the occurrence of the body movement, the re-measurement including the dummy scan is started. In this case, the dummy scan is performed until the phase encoding step for the low frequency region is reached, and, in the main scan for re-measurement, data measurement is started from the phase encoding step at which the transition from the high frequency region to the low frequency region is made. Therefore, in this re-measurement C, among the high frequency data, the phase encoding data from the occurrence of the body movement to the start of the dummy scan and the phase encoding data during the dummy scan (phase encoding data indicated by diagonal lines in Fig. 10) are left unmeasured.

In the example shown on the lower side of Fig. 10 (re-measurement D), the time point at which the body movement occurs during the imaging is the same as that of the upper side of Fig. 10, but, in the re-measurement, the measurement of the phase encoding data from the occurrence of the body movement to the start of the dummy scan is omitted, and, in the main scan, the measurement of the phase encoding data thereafter is performed. As shown on the right side of Fig. 10, in both the re-measurement C and the re-measurement D, the measurement of the high frequency data in the k-space is omitted, and thus it is possible to suppress the extension in time due to the insertion of the dummy scan. In particular, in a case of the re-measurement C, the number of data points to be omitted is set to be equal to or less than the number of shots of the dummy scan, so that it is possible to eliminate the extension in time due to the dummy scan.

Whether to perform the re-measurement C or the re-measurement D may be determined by setting any one of them as default, or may be automatically determined by the imaging controller 210 based on the number of high frequency data that are not measured and the re-measurement time (restriction on extension time) that is extended by measuring the high frequency data.

Fig. 11 is a diagram showing an example of control in a case where a body movement occurs during measurement of the low frequency data. In a case where the body movement occurs during the measurement of the low frequency data, the low frequency data affected by the body movement (low frequency data to be deleted) is re-measured in the re-measurement, but the measurement of at least a part of the high frequency data is omitted after the transition from the low frequency region to the high frequency region in the re-measurement.

The position and number of the high frequency data for which data is not collected depend on the k-space position and number of the k-space data (region B in Fig. 5) determined to be in the body movement range and of the data following the body movement range. In theory, in a case where k-space high frequency data that is symmetrical with the k-space high frequency data collected by the normal imaging is not measured due to the interruption of the imaging, the measurement of all the unmeasured k-space high frequency data corresponding to the measured k-space high frequency data can be omitted. However, in a case where the purpose is to cancel the time extension due to the dummy scan, the measurement of the same number of data as the number of dummy echoes (period DT of the dummy scan) set in advance among the unmeasured k-space high frequency data may be omitted. Accordingly, the imaging time can be shortened by the same time OT as the period DT of the dummy scan.

As an example, in a case where a predetermined number of dummy echoes is set in advance, the imaging controller 210 compares the number of unmeasured k-space high frequency data with the set number of dummy echoes, and, in a case where the former is larger than the latter, the imaging controller 210 omits the measurement of the k-space high frequency data of the same number as the number of dummy echoes. On the other hand, a configuration may be adopted in which, in a case where the number of unmeasured k-space high frequency data is smaller than the number of dummy echoes, control of omitting all the unmeasured k-space high frequency data is performed. However, in the present embodiment, it is sufficient to omit at least a part of the unmeasured k-space high frequency data, and this control is merely an example and is not limited to this.

In addition, the data region for which measurement is omitted is not limited as long as it is a high frequency region, but may be, for example, data of consecutive phase encoding steps spanning from the outermost high frequency side to a predetermined phase encoding step, as shown on the lower side of Fig. 11. Alternatively, the data region may be thinned out in the phase-encoding direction. A thinning-out rate is, for example, "(number of high frequency data points - number of dummy shots)/number of high frequency data points". Note that, in this case, it is assumed that the number of unmeasured k-space high frequency data is larger than the number of dummy echoes.

The image generation unit 220 performs image reconstruction using k-space data in which a part of the high frequency data is not measured. In the image reconstruction, for example, the image is generated by a method, such as performing the image reconstruction after zero-filling of unmeasured high frequency data, performing the image reconstruction through data estimation using a sensitivity distribution, or performing sequential reconstruction after zero-filling, as in the body movement correction image reconstruction.

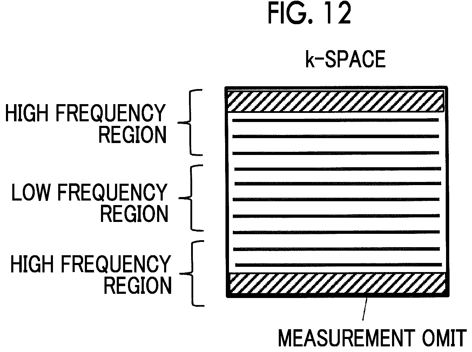

In Figs. 10 and 11, a case where the measurement of one of the upper and lower high frequency data in the k-space is omitted according to the phase encoding position at the time point at which the body movement occurs is shown. However, as shown in Fig. 12, it is also possible to omit the measurement of both the upper and lower high frequency data depending on the phase encoding position at the time of the occurrence of the body movement. In that case, by setting the number of data to be omitted to be about the same as the number of shots of the dummy scan, the dummy scan period DT can be canceled in the same manner as in a case where the measurement of the high frequency data on one side is omitted, and the extension in re-measurement time can be suppressed. In a case where the measurement of the high frequency data on both sides is omitted, for example, it is possible to control so that, for the high frequency data on both sides having different polarities, one of the data with the same phase encoding is kept and the other is omitted. As a result, one of data pairs having Hermitian symmetry in the phase encoding direction of the k-space remains, and more information in the high frequency region of the original data can be maintained.

According to the present embodiment, by not acquiring a part of the high frequency data, the re-measurement time can be shortened, and the time extended by the dummy scan can be offset (canceled). Accordingly, there is no substantial extension in the re-measurement time, and the extension in imaging time in a case where the re-measurement is necessary can be reduced.

Although the embodiments and the modification examples of the present invention have been described above, the present invention is not limited to these embodiments, and the present invention also includes adding other known elements or omitting non-essential elements. In addition, these embodiments and modification examples can be combined as appropriate as long as there is no technical contradiction, and such embodiments are also included in the present invention.

### Explanation of References

1: MRI apparatus
10: imaging unit
20: processor
210: imaging controller
220: image generation unit
230: body movement processing unit

## Claims

1. A magnetic resonance imaging apparatus comprising:
an imaging unit that collects nuclear magnetic resonance signals of a subject; and
one or more processors configured to reconstruct an image of the subject using k-space data consisting of the nuclear magnetic resonance signals collected by the imaging unit, analyze a body movement of the subject during imaging to specify correction target data affected by the body movement of the subject, and control the imaging unit,
wherein, in a case where it is determined that re-measurement of the correction target data is necessary, the one or more processors set a condition for the re-measurement, control the imaging unit, and execute a dummy scan of performing one or more times of RF pulse irradiation to generate dummy signals that are not used for image reconstruction, before the re-measurement of the correction target data.

2. The magnetic resonance imaging apparatus according to claim 1,
wherein the one or more processors execute the dummy scan for a preset period or a preset number of times of the RF pulse irradiation.

3. The magnetic resonance imaging apparatus according to claim 1 or 2,
wherein the one or more processors execute the dummy scan without applying phase encoding to the dummy signals.

4. The magnetic resonance imaging apparatus according to claim 1 or 2,
wherein the one or more processors execute the dummy scan by applying phase encoding to the dummy signals.

5. The magnetic resonance imaging apparatus according to claim 4,
wherein the one or more processors execute the dummy scan by sequentially applying phase encoding steps from phase encoding retraced from first phase encoding of the correction target data in a signal measurement order to the first phase encoding.

6. The magnetic resonance imaging apparatus according to any one of the preceding claims,
wherein the one or more processors refer to an arrangement of the correction target data in a k-space, and
in a case where the correction target data is high frequency data in the k-space, the one or more processors adjust a period of the dummy scan or the number of times of the RF pulse irradiation.

7. The magnetic resonance imaging apparatus according to any one of the preceding claims,
wherein the one or more processors refer to an arrangement of the correction target data in a k-space, and
in a case where the correction target data includes high frequency data in the k-space, the one or more processors perform the re-measurement by omitting at least a part of high frequency data collected in the re-measurement.

8. The magnetic resonance imaging apparatus according to any one of the preceding claims,
wherein the one or more processors omit measurement of high frequency data in a k-space, which is measurable in a measurement time equivalent to a time of the dummy scan, in the re-measurement.

9. A method of controlling a magnetic resonance imaging apparatus, the method comprising:
a step of specifying correction target data affected by a body movement of a subject in k-space data acquired during imaging; and
a step of controlling imaging to execute a dummy scan of performing one or more times of RF pulse irradiation to generate dummy signals that are not used for image reconstruction, in a case where the correction target data is re-measured.

10. The method of controlling a magnetic resonance imaging apparatus according to claim 9, further comprising:
a step of determining a condition including a period of the dummy scan or the number of times of the RF pulse irradiation as a condition of the dummy scan, before the step of controlling the imaging.
